(19) **Europäisches Patentamt**
**European Patent Office**
**Office européen des brevets**

(11) **EP 3 168 948 A1**

(12) **EUROPEAN PATENT APPLICATION**
published in accordance with Art. 153(4) EPC

(43) Date of publication:
**17.05.2017 Bulletin 2017/20**

(21) Application number: **15818713.8**

(22) Date of filing: **03.07.2015**

(51) Int Cl.:
***H02J 3/00*** (2006.01) ***G06Q 50/06*** (2012.01)

(86) International application number:
**PCT/JP2015/069282**

(87) International publication number:
**WO 2016/006549 (14.01.2016 Gazette 2016/02)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(30) Priority: **11.07.2014 JP 2014143148**

(71) Applicant: **Kabushiki Kaisha Toshiba**
**Minato-ku**
**Tokyo 105-8001 (JP)**

(72) Inventors:
• **MURAI Masahiko**
**Tokyo 105-8001 (JP)**
• **AKASHI Masakuni**
**Tokyo 105-8001 (JP)**
• **MURAYAMA Dai**
**Tokyo 105-8001 (JP)**
• **SAITO Masaaki**
**Tokyo 105-8001 (JP)**
• **OTAKE Hiroaki**
**Tokyo 105-8001 (JP)**
• **ASAKURA Hiraku**
**Tokyo 105-8001 (JP)**
• **NOSAKA Takao**
**Tokyo 105-8001 (JP)**

(74) Representative: **Moreland, David**
**Marks & Clerk LLP**
**Aurora**
**120 Bothwell Street**
**Glasgow G2 7JS (GB)**

(54) **INFORMATION PROCESSING DEVICE, INFORMATION PROCESSING METHOD, AND STORAGE MEDIUM**

(57) An information processing apparatus of the embodiment includes a calculator. The calculator acquires an amount of primary energy consumption at timings in a period of time and an amount of primary energy production at timings in the period of time. The amount of primary energy consumptions has been consumed and/or is estimated to be consumed by a plurality of energy-supplying apparatuses configured to supply energy to a load. The amount of primary energy productions has been produced and/or is estimated to be produced by the plurality of energy-supplying apparatuses. The calculator calculates a net amount of primary energy consumption at the timings in the period of time, based on the acquired amount of primary energy consumption and the amount of primary energy production. The calculator calculates an integrated value of the net amounts of primary energy consumption over the period of time, based on the net amounts of primary energy consumption calculated at the timings in the period of time.

FIG. 1

EP 3 168 948 A1

**Description**

[Field of Art]

Embodiments of the present invention relate to an information processing apparatus, an information processing method, and a storage medium.

[Background Art]

In recent years, because of environmental concerns the achievement of zero energy buildings (ZEB) for structures has been promoted. A zero-energy building is defined by Ministry of Economy, Trade and Industry as a building for which the amount of primary energy consumption of a building is reduced by the improvement of energy-saving performance of the building and equipment, the use of mutual lateral sharing of energy, the on-site use of renewable energy, and the like, so as to result in a net primary energy consumption amount of zero or substantially zero over a period of a year.

However, because many conventional buildings purchased energy and did not produce energy, in those buildings there has been no clear demand to know what a net amount of consumption of primary energy, which will hereinafter be referred to as a net amount of primary energy consumption. Therefore, there have been cases in which it is not possible to indicate the net amount of primary energy consumption in an easy-to-understand form, and in which it is difficult to judge whether a building could achieve ZEB.

[Prior Art Reference]

[Patent Reference]

[Patent Reference 1]: Japanese Patent Application Publication No. 2012-103811

[Summary of the Invention]

[Problem to Be Solved by the Invention]

The problem the present invention seeks to solve is that of providing an information processing apparatus, an information processing method, and a storage medium capable of calculating the integrated value of the net amounts of primary energy consumption in a load.

[Means to Solve the Problem]

An information processing apparatus of an embodiment has a calculator. The calculator acquires an amount of primary energy consumption at each prescribed timing by a plurality of energy-supplying apparatuses supplying energy to a load and an amount of primary energy production at each prescribed timing by the plurality of energy-supplying apparatuses, calculates a net amount of primary energy consumption at each prescribed timing based on the acquired amount of primary energy consumption and the amount of primary energy production, and calculates the integrated value of net amounts of primary energy consumption in a prescribed time period, based on the calculated net amount of primary energy consumption at each prescribed timing.

[Brief Description of the Drawings]

FIG. 1 is a block diagram showing the general constitution of an energy management system of a first embodiment.
FIG. 2 is a block diagram showing the general constitution of an energy management apparatus of the first embodiment.
FIG. 3 shows an example of the relationship between the electrical power load predicted value calculated by the energy management apparatus of the first embodiment and the actually measured values.
FIG. 4 shows an example of the time variation of the absolute value of the difference between the electrical power load predicted value calculated by the energy management apparatus of the first embodiment and the actually measured values.
FIG. 5 shows an example of the time variation of the performance evaluation index of the energy-supplying apparatus calculated by the energy management apparatus of the first embodiment.

FIG. 6 shows an example of the time variation of the absolute value of the difference between the actual and predicted values regarding the performance evaluation index of the energy-supplying apparatus calculated by the energy management apparatus of the first embodiment.

FIG. 7 is a block diagram showing the general constitution of a terminal device of the first embodiment.

FIG. 8 is a flowchart showing a first example of the operation of an energy management apparatus of the first embodiment.

FIG. 9 shows one example of the relationship between the actual value of the consumption amount, the actual value of the production amount, and the actual integrated value of the net amounts of primary energy consumption calculated by the energy management apparatus of the first embodiment.

FIG. 10 is a flowchart showing a second example of the operation of the energy management apparatus of the first embodiment.

FIG. 11 shows one example of the relationship between the predicted value of the production amount, the predicted value of the consumption amount, and the predicted value of integration of the net amounts of primary energy consumption calculated by the energy management apparatus of the first embodiment.

FIG. 12 is a flowchart showing a third example of the operation of the energy management apparatus of the first embodiment.

FIG. 13 shows one example of updating based on the actual value with regard to the predicted value of the production amount, the predicted value of consumption amount, and the predicted value of integration of the net amounts of primary energy consumption calculated by the energy management apparatus of the first embodiment.

FIG. 14 shows another example of the predicted value of integration of the net amounts of primary energy consumption calculated by the energy management apparatus of the first embodiment.

FIG. 15 is a block diagram showing the general constitution of a variation example of the energy management system of the first embodiment.

[Embodiments]

Information processing apparatuses according to embodiments will be described below, with references made to the drawings.

(First Embodiment)

The information processing apparatus according to the present embodiment has a function of calculating the integrated value of the net amounts of primary energy consumption (production amount) by a plurality of energy-supplying apparatuses supplying energy to a load. The information processing apparatus or a terminal device that communicates with the information processing apparatus may have a function of displaying the integrated value of net amounts of primary energy consumption (production amount) calculated by the information processing apparatus.

By doing this, because the information processing apparatus or terminal device can, for example, indicate the degree of net amount of primary energy consumption (production amount) of a building over a period of a year, it enables a user to easily judge whether it is possible for the building achieve being a ZEB.

The load refers to a building, structure, facility, or equipment that accepts and consumes energy including, for example, a commercial building or dwelling.

Primary energy is energy taken directly from nature, such as coal, petroleum, natural gas, wood, hydraulic power, nuclear power, wind power, tidal flow, geothermal heat and solar energy. The primary energy amount is calculated by multiply the consumed or produced electrical energy, heat, or heat energy amount and consumed amount of fuel by individual primary energy conversion coefficients.

The net amount of primary energy consumption is the amount of primary energy consumed by energy-supplying apparatuses in generating electrical power, heat, and cold minus the amount of primary energy produced by the energy-supplying apparatus. The amount of primary energy production is calculated by multiplying the amount of renewable energy produced by solar electrical generation, biomass cogeneration, and the like by a primary energy conversion coefficient. In the following, although the energy management apparatus 1 will be described as calculating the net amount of primary energy consumption, it may calculate the net amount of primary energy production in place of the net amount of primary energy consumption. The primary energy net production amount is acquired by reversing the sign (positive or negative) of the net amount of primary energy production. That is, the net amount of primary energy consumption and the primary energy net production amount are mutually interchangeable and, for example, indicate information of the same type regarding whether or not a building can achieve being a ZEB.

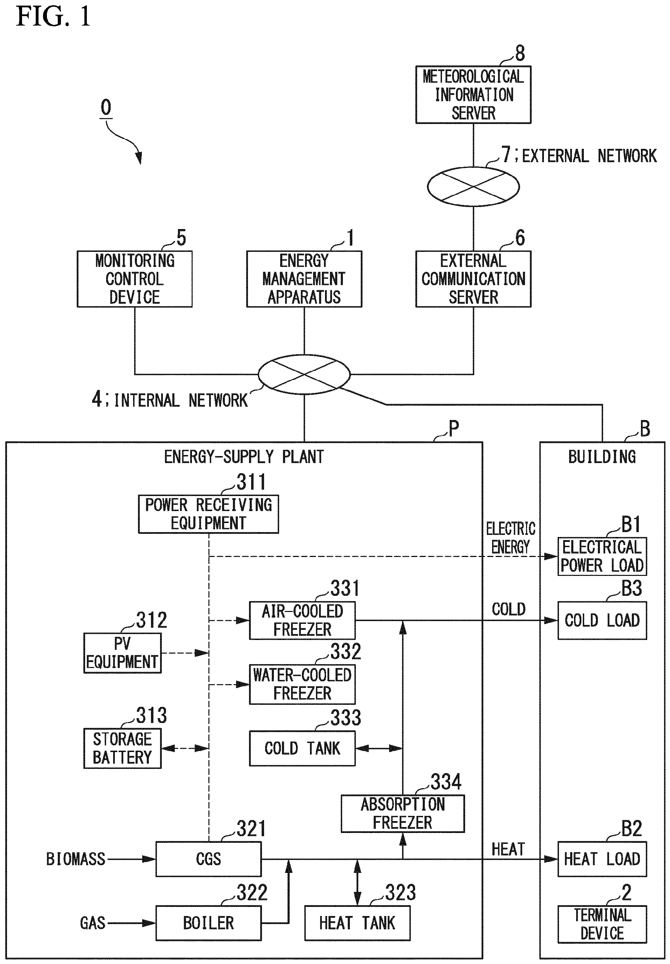

The constitution of an energy management system 0 that includes an information processing apparatus will be described below, with reference made to FIG. 1.

FIG. 1 is a block diagram showing the general constitution of the energy management apparatus 1.

The energy management system 0 of the present embodiment has an energy management apparatus 1, a terminal device 2, a plurality of energy-supplying apparatuses, a monitoring control device 5, and an external communication server 6. These devices are connected so as to be able to mutually communicate via the internal network 4, either by cable or wirelessly.

The energy management apparatus 1 is an information processing apparatus of the present embodiment and calculates the integrated value of the net amounts of primary energy consumption by a plurality of energy-supplying apparatuses. The energy management apparatus 1 is, for example, a server device.

The terminal device 2 is an electronic device such as a personal computer, a mobile telephone, a tablet, a smartphone, a PHS (Personal Handy-phone System) terminal device, or a PDA (personal digital assistant). The terminal device 2 may be installed, for example, inside the building B that is the load in the present embodiment.

The energy-supplying devices supply energy such as electrical power, heat, or cold to a load. The type, number, and form of connection of the energy-supplying devices is arbitrary and may be changed in accordance with the load. Although the energy-supplying devices are shown as an example in the present embodiment as being installed within an energy-supply plant P, the energy-supplying devices may be installed in a distributed manner, among a plurality of facilities. The energy-supplying devices supply electrical power, cold, and heat to the electrical power load B1, the heat load B2, and the cold load B3 in accordance with the demand amount of the building B. Heat and cold energy is supplied in the form of, for example, water.

Power receiving equipment 311, PV (photovoltaic) equipment 312, a storage battery 313, a CGS (co-generation system) 321, a boiler 322, a heat tank 323, a air-cooled freezer 331, a water-cooled freezer 332, a cold tank 333, and an absorption freezer 334 are installed inside the energy-supply plant P.

The power receiving equipment 311 receives electrical power from an electric power company and converts it a voltage suitable for the facilities.

The PV equipment 312 is electrical power generating equipment that has solar panels that convert the energy of sunlight to electrical energy. The amount of electrical energy supplied by the PV equipment 312 changes in accordance with meteorological conditions such as the weather.

The storage battery 313 is equipment that uses a secondary battery capable of both charging and discharging.

The CGS 321 is a system that can generate electricity by means of an internal combustion engine or an external combustion engine, and that can also use the exhaust heat therefrom as heat. Although the CGS 321 in the present embodiment uses biomass fuel as an energy source, gas may also be used as an energy source.

The boiler 322 supplies heat, using gas as an energy source.

The heat tank 323 stores heat by a heat medium accumulated therein. The cold tank 333 is, for example, a water heat storage tank.

The air-cooled freezer 331 is a device that supplies cold water by a phase change of a refrigerant, with air as the heat source.

The water-cooled freezer 332 is a device that supplies cold water by a phase change of a refrigerant, with water as the energy source.

The cold tank 333 stores heat by a heating medium accumulated therein. The cold tank 333 is, for example, a water heat storage tank or an ice heat storage tank.

The absorption freezer 334 is a device that supplies cold water by intervening between in process of steam absorption and regeneration by a heat source between a refrigerant condenser and evaporator.

As shown in FIG. 1, the power receiving equipment 311, the PV equipment 312, the storage battery 313, and the CGS 321 supply electrical power to the electrical power load B1. The CGS 321, the boiler 322, and the heat tank 323 supply heat to the heat load B2. The air-cooled freezer 331, the water-cooled freezer 332, the cold tank 333, and the absorption freezer 334 supply cold to the cold load B3.

The monitoring control device 5, for example, is a server device, which controls the energy-supplying devices installed in the energy-supply plant P so as to supply electrical power, heat, and cold to the electrical power load B1, the heat load B2, and the cold load B3 of the building B, which constantly change with time. The monitoring control device 5, in addition to storing process data of the energy-supplying devices, monitors operating states such as whether or not the energy-supplying devices are operating normally.

The external communication server 6 is a server device that is connected to the internal network 4 and the external network 7, and that relays transmission and receiving between devices connected to the internal network 4 and devices connected to the external network 7. For example, the external communication server 6 communicates with the meteorological information server 8 in response to a request from the energy management apparatus 1. The external communication server 6 transmits data obtained from the meteorological information server 8 to the energy management apparatus 1.

The meteorological information server 8 manages past meteorological record information and future meteorological forecast information. The meteorological information server 8 is connected to the external network 7 and communicates with the external communication server 6. The meteorological information server 8, for example, in response to a request from the external communication server 6 to obtain data, transmits meteorological data, which includes past meteorological record information that itself manages and future meteorological forecast information.

The internal network 4 and the external network 7 are information communication networks that are constituted by, for example, a WAN (wide area network) or a LAN (local area network).

A WAN is implemented, for example, by a mobile telephone network, a PHS network, a PSTN (public switched telephone network), a dedicated communication circuit network, or a VPN (virtual private network).

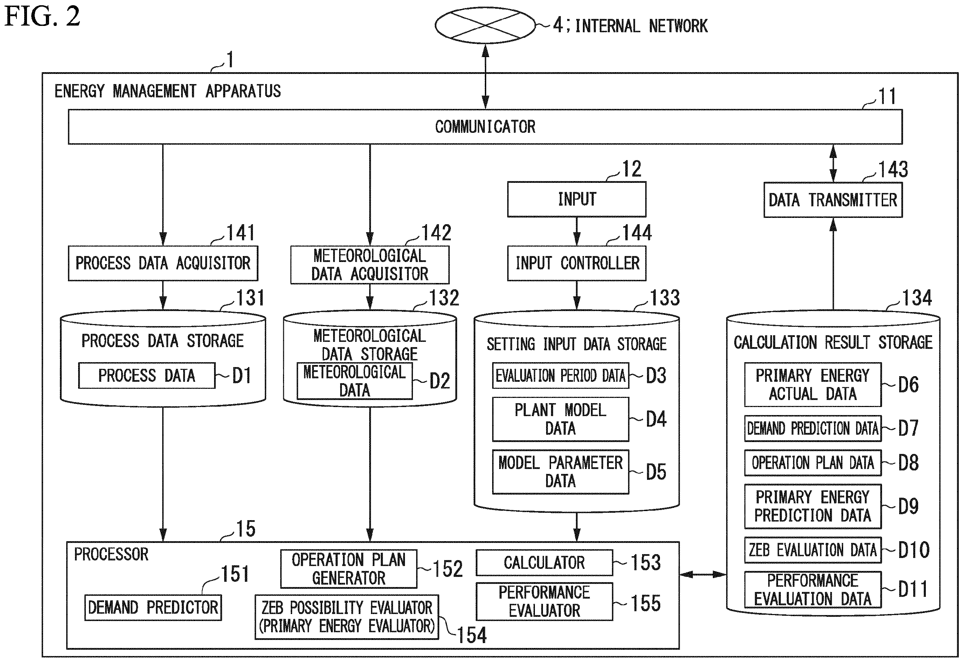

Next, referring to FIG. 2, the constitution of the energy management apparatus 1 will be described.

FIG. 2 is a block diagram showing the general constitution of the energy management apparatus 1.

The energy management apparatus 1 has a communicator 11, an input 12, a storage, and a controller.

The communicator 11 has a communication interface. The communicator 11 communicates with the monitoring control device 5 (FIG. 1) and the external communication server 6 (FIG. 1), via the internal network 4.

The input 12 has an input device such as a touch panel, a mouse, or a keyboard, and accepts data input from a user. The input 12, for example, accepts input of data such as evaluation period data, energy-supply plant P plant model data, and model parameter data of energy-supplying devices installed in the energy-supply plant P. The evaluation period data, plant model data, and model parameter data will be described later. The input 12 may have a communication interface for communicating with an external storage device that stores evaluation period data, plant model data, or model parameter data and may receive evaluation period data, plant model data, or model parameter data from the external storage device.

The storage of the energy management apparatus 1 has, for example, a ROM (read-only memory), a RAM (random-access memory), or an EEPROM (electrically erasable programmable read-only memory). The storage may also be an external storage device such as a HDD (hard-disk drive) or a flash memory. The storage stores various programs for execution by a CPU (not shown) of the energy management apparatus 1 and the results of processing executed by the CPU. The storage functions a process data storage 131, a meteorological data storage 132, a setting input data storage 133, and a calculation result storage 134.

The process data storage 131, the meteorological data storage 132, the setting input data storage 133, and the calculation result storage 134 and the data stored therein will now be described.

The process data storage 131 stores the process data D1.

The process data D 1 includes, for example, information of operating records of energy-supplying devices within the energy-supply plant P (FIG. 1) and records of the amount of energy demand of the building B (electrical power load B1, heat load B2, and cold load B3). This information is stored in association with the date and time, the time interval thereof being, for example, one-hour units.

In the present embodiment, the date and time refers to the year, month, day and the time (hour, minute, second). In the date and time, a part, such as the minute or second, may be omitted.

The meteorological data storage 132 stores the meteorological data D2.

The meteorological data D2 includes meteorological information such as the weather and amount of sunshine, the sunshine time, the temperature, and the humidity, which can influence the energy demand of the building B (FIG. 1) or the energy generation efficiency of energy-supplying devices in the energy-supply plant P (FIG. 1). This information is stored in association with the date and time, the time interval thereof being, for example, one-hour units. The meteorological data D2 includes information, in addition to the past meteorological records, of future meteorological forecasts such as the weather forecast.

The setting input data storage 133 stores the evaluation period data D3, the plant model data D4, and the model parameter data D5.

The evaluation period data D3 establishes the evaluation period in the various processing performed by the processor 15 of the energy management apparatus 1. The evaluation period establishes the range of data referencing in the various processing done by the processor 15, for example, when the net amount of primary energy consumption is integrated, it establishes the time over which the accumulation is done. If the evaluation period data D3 is established, for example, as the period from April 1, 2014 until March 31, 2015, the processor 15 references and processing the process data D1, the meteorological data D2, the primary energy actual data D6, the demand prediction data D7, the operation plan data D8, and the primary energy prediction data D9 and the like, which are associated with the date and time within the time period. The evaluation period may be arbitrarily established by the user. For example, if an evaluation is to be made as to whether or not the building B can achieve being a ZEB, because it is necessary to calculate the integrated value of the net amounts of primary energy consumption for a period of a year, the evaluation period is one year.

The plant model data D4 indicates the form of the energy-supply plant P (FIG. 1). The plant model data D4, for example, indicates the type and form of connection of the energy-supplying devices of the energy-supply plant P.

The model parameter data D5 indicates the details of energy-supplying devices installed in the energy-supply plant P (FIG. 1). The model parameter data D5, for example, includes information such as the maximum output of energy supplied from each of the energy-supplying devices, and the output energy conversion efficiency with respect to the input energy of each of the energy-supplying devices.

The conversion efficiency is, for example, the COP (coefficient of performance) of the air-cooled freezer 331, the water-cooled freezer 332, and the absorption freezer 334, the electrical generation efficiency, heat exhaust reclamation efficiency, and the overall efficiency of the CGS 321, and the boiler efficiency of the boiler 322.

The model parameter data D5 also includes information indicating, for the PV equipment 312, the energy generation efficiency of which changes in accordance with the meteorological conditions, the energy output value in accordance with meteorological conditions. The energy conversion efficiencies and energy generation efficiency are indexes (performance evaluation indexes) that evaluate the performance of each energy-supplying device.

The model parameter data D5 includes data of the amount of energy that can be stored by the storage battery 313, the heat tank 323, and the cold tank 333. The model parameter data D5 also includes information of the energy unit prices for each date and time for electrical power received by the power receiving equipment 311, the biomass fuel consumed by the CGS 321, and the gas consumed by the boiler 322. The model parameter data D5 includes, for example, the primary energy conversion efficiency of electrical power, gas, and biomass fuel.

The calculation result storage 134 stores the results of computational processing by the processor 15. Specifically, it stores the primary energy actual data D6, the demand prediction data D7, the operation plan data D8, the primary energy prediction data D9, the ZEB evaluation data D10, and the performance evaluation data D11.

The primary energy actual data D6 includes information of the performance value of the amount of primary energy consumption of all the energy-supplying devices installed in the energy-supply plant P (FIG. 1), the performance value of the primary energy generation amount, and the performance value of the integrated value of the net amounts of primary energy consumption, which will hereinafter be referred to as an actual integrated value. These performance values are stored in association with the date and time, the time interval thereof being, for example, one-hour units.

A performance value is a value calculated based on operation records of an energy-supplying device. That is, the performance value of the amount of primary energy consumption, the performance value of the amount of primary energy production, and the performance value of the net amount of primary energy consumption are, respectively, integrated values of the actually amounts of primary energy consumption, the actual amount of primary energy production, and the actual net amount of primary energy consumption.

The demand prediction data D7 is prediction data for a year of demand of the building B. The demand prediction data D7 includes, for example, information of the predicted values of the electrical power load B1, the heat load B2, and the cold load B3. The predicted values of the electrical power load B1, the heat load B2, and the cold load B3 are stored in association with the date and time, the time interval thereof being, for example, one-hour units.

The operation plan data D8 indicates a year's operation plan for the energy-supplying devices in the energy-supply plant P. The operation plan data D8 indicates control setting values that indicate, for example, the starting and stopping of the energy-supplying devices and the output level thereof when operating. The control setting values are stored, for example, in association with a date and time, the time interval thereof being, for example one-hour units.

The primary energy prediction data D9 indicates the predicted value of the amount of primary energy consumption for all the energy-supplying devices installed in the energy-supply plant P, the predicted value of primary energy production, and the predicted value of integration of the net amounts of primary energy consumption , which will hereinafter be referred as to a predicted value of integration. Each of these predicted values is stored in association with the date and time, the time interval thereof being, for example, one-hour units.

The ZEB evaluation data D10 is the result of evaluation regarding whether or not the building B (FIG. 1) can achieve being a ZEB.

The performance evaluation data D11 represents the results of evaluation regarding whether or not the expected performance is being exhibited by the energy-supplying devices installed in the energy-supply plant P (FIG. 1).

Next, the controller of the energy management apparatus 1 will be described.

A part or all of the functions of the controller of the energy management apparatus 1 is implemented, for example, by execution of a program stored in the storage of the energy management apparatus 1 by a CPU (not shown) of the energy management apparatus 1.

The controller of the energy management apparatus 1 functions as a process data acquisitor 141, a meteorological data acquisitor 142, a data transmitter 143, an input controller 144, and the processor 15.

The process data acquisitor 141 acquires process data of energy-supplying devices installed in the energy-supply plant P (FIG. 1) from the monitoring control device 5 (FIG. 1), via the communicator 11. In this case, the process data acquisitor 141 may acquire process data directly from the energy-supplying devices installed in the energy-supply plant P. The process data acquisitor 141 stores the acquired process data into the process data storage 131.

The meteorological data acquisitor 142 communicates with the external communication server 6 (FIG. 1) via the communicator 11, and acquires the meteorological data D2 from the meteorological information server 8 (FIG. 1) via the external communication server 6. The meteorological data acquisitor 142 stores the acquired meteorological data D2 into the meteorological data storage 132.

In response to a data transmission request accepted from the terminal device 2 (FIG. 1), the data transmitter 143, for example, reads out from the calculation result storage 134 the primary energy actual data D6, the demand prediction data D7, the operation plan data D8, the primary energy prediction data D9, and the performance evaluation data D11, and the like. The data transmitter 143 transmits the various read-out data to the terminal device 2 originating the request, via the communicator 11.

The input controller 144 stores the evaluation period data D3, the plant model data D4, and the model parameter data D5 accepted by the input 12 into the setting input data storage 133.

The processor 15 references the process data D1 stored in the process data storage 131, the meteorological data D2 stored in the meteorological data storage 132, the evaluation period data D3, the plant model data D4, and the model parameter data D5 stored in the setting input data storage 133, and generates and stores into the calculation result storage 134 the primary energy actual data D6, the demand prediction data D7, the operation plan data D8, the primary energy prediction data D9, and the performance evaluation data D11.

More specifically, the processor 15 calculates the integrated value of actual amounts of primary energy consumption, the amount of primary energy production, and the net amount of primary energy consumption of all the energy-supplying devices installed in building B (FIG. 1) and the energy-supply plant P (FIG. 1). The processor 15 predicts the energy demand of the building B and generates an operation plan for the energy-supplying devices of the energy-supply plant P in order to supply the amount of energy responsive to the predicted energy demand. The processor 15, based on the predicted energy demand and the generated operation plan, calculates the predicted value of integration of amounts of primary energy consumption, the amount of primary energy production, and the net amount of primary energy consumption. It also evaluates, from the calculated net amount of primary energy consumption actual value and predicted value, the possibility of achieving being a ZEB, and outputs the result.

The processor 15 has a demand predictor 151, an operation plan generator 152, a calculator 153, a ZEB possibility evaluator (primary energy evaluator) 154, and a performance evaluator 155.

The demand predictor 151 acquires the process data D1 and the meteorological data D2 and, based on the acquired process data D1 and meteorological data D2, predicts the energy demand amount by the building B (FIG. 1).

The specific processing in the predicting of the building B energy demand amount by the demand predictor 151 will now be described.

The demand predictor 151, for example, calculates the average value of the past energy demand at a prescribed timing, for example, every one hour, and calculates the change of the energy demand with time over an average day during a year. The energy demand amount of the building B corresponding to each time, for example, is obtained by taking the overall total of the output energy amount of each of the energy-supplying device at associated times in the process data D1. In this case, for example, the electrical power load B1 of the building B corresponding to each of the times from 0000 to 2300 are taken to be B1(0) to B1(23). If the demand is to be predicted based on one year of process data D1, the demand predictor 151 calculates the electrical power loads B1(0) to B1(23) for each day from the 1st day to the 365th day. The demand predictor 151 calculates the average value for each time with regard to the calculated electrical power loads B1(0) to B1(23) so as to obtain a demand predicted value at each of the times. The demand predictor 151, for example, obtains the electrical power load B1 predicted values for the times 0000, 0100, ..., 2300 by calculating the average values of the electrical power load B1(0), B1(1), ..., B1(23) from the 1st to the 365th day.

The demand predictor 151 may perform the same type of processing as for the electrical power load B1 to obtain the predicted values of the heat load B2 and the cold load B3. The demand predictor 151 may predict the time change of the energy demand over one year by treating the time change of the energy demand calculated in this manner for one day as repeating for 365 days.

The demand predictor 151, for example, calculates the average value of the energy demand for one month at each of the times for the past one year and calculates the time change of the energy demand of an average day in a one-month period. This calculation may be performed every month, so that the demand predictor 151 calculates the time change of the energy demand with regard to an average day during each of the 12 months. By treating the calculated time change of the energy demand in one day as repeating each month, the demand predictor 151 may predict the time change of the energy demand for one year. The demand predictor 151 stores the demand prediction data D7, which indicates the predicted one-year energy demand time change, into the calculation result storage 134.

Although in the above-described example of specific processing in the predicting of the energy demand amount, to simplify the description the meteorological data D2 has not been used, the demand predictor 151 may perform prediction of the energy demand amount by the building B, based on the meteorological data D2.

The description of the constitution of the energy management apparatus 1 will now be continued.

Based on the plant model data D4, the model parameter data D5, and the demand prediction data D7, the operation plan generator 152 generates the operation plan of the energy-supplying devices installed in the energy-supply plant P. For example, the operation plan generator 152 generates an operation plan that minimizes the energy cost, while satisfying the constraining conditions in the operation of the energy-supply plant P (FIG. 1). In this case, a constraining condition is, for example, is the integrated value of the net amounts of primary energy consumption by all the energy-supplying devices supplying energy to the building B (FIG. 1) over a period of a year being zero or a negative value, that is, the integrated value of the net amounts of primary energy production being zero or a positive value. The energy cost is the expense required for the energy-supplying devices to generate energy. The energy cost varies by the season, the time of the day, and the like. The energy cost differs in accordance with the energy-supplying device generating the energy. Mathematical programming or heuristics, for example, can be used as a method for minimizing the energy cost. The operation plan generator 152 stores the operation plan data D8 indicating the generated operation plan into the calculation result storage 134.

The calculator 153 performs processing to calculate the actual value and predicted value regarding the integrated value of the net amounts of primary energy consumption in the evaluation period. The calculation of the actual value and the predicted value by the calculator 153 will be described in sequence.

If the actual value of the amount of primary energy consumption or the like is to be calculated, the calculator 153 acquires the evaluation period data D3 and acquires the process data D1 corresponding to the evaluation period indicated by the acquired evaluation period data D3. The calculator 153 also acquires the plant model data D4 and the model parameter data D5. Based on the acquired process data D1, plant model data D4, and model parameter data D5, the calculator 153 calculates the actual value of the amount of primary energy consumption, the actual value of the amount of primary energy production, and the integrated value of actual net amounts of primary energy consumption by all the energy-supplying devices installed in the energy-supply plant P (FIG. 1).

In this manner, because the calculator 153 calculates the integrated value of actual net amounts of primary energy consumption, the terminal device 2 can display the integrated value of actual net amounts of primary energy consumption as will be described later. Therefore, the energy management system 0, for example, can indicate to a user in easy-to-understand form whether or not the building B can actually achieve being a ZEB.

The actual value of the amount of primary energy consumption and the actual value of the amount of primary energy production may be calculated, for example, by another apparatus. The calculator 153 may then acquire information of the actual value of the amount of primary energy consumption and the actual value of the amount of primary energy production calculated by the other apparatus and, based on the acquired information, calculate the integrated value of actual net amounts of primary energy consumption.

If the predicted value of primary energy consumption or the like is to be calculated, the calculator 153 acquires the evaluation period data D3 and acquires the demand prediction data D7 and operation plan data D8 corresponding to the evaluation period indicated by the acquired evaluation period data D3. The calculator 153 also acquires the plant model data D4 and the model parameter data D5. Based on the acquired plant model data D4, model parameter data D5, demand prediction data D7, and operation plan data D8, the calculator 153 calculates the predicted value of primary energy consumption, the predicted value of primary energy production, and the predicted value of integration of net amounts of primary energy consumption of all the energy-supplying devices installed in the energy-supply plant. The calculator 153 generates the primary energy actual data D6, which includes information indicating the various calculated values and predicted values, and stores the generated primary energy actual data D6 into the calculation result storage 134.

In this manner, by the calculator 153 calculating the predicted value of actual net amounts of primary energy consumption, as will be described later, the terminal device 2 can display the predicted value of integration of net amounts of primary energy consumption. Therefore, the energy management system 0, for example, can indicate to a user in easy-to-understand form whether or not the building B can actually achieve being a ZEB at the completion of the evaluation period.

The predicted value of primary energy consumption and the predicted value of primary energy production may be calculated, for example, by another apparatus. The calculator 153 may then acquire information of the predicted value of primary energy consumption and the predicted value of primary energy production from the other apparatus and, based on the acquired information, calculate the integrated value of actual net amounts of primary energy consumption.

The equations used by the calculator 153 to calculate the integrated value of actual net amounts of primary energy consumption and the predicted value of integration of net amounts of primary energy consumption will now be described.

The amount of primary energy consumption $E_c$ (d, t) at time t on the d-th day from the start of the evaluation is the sum of the value of the demanded electrical power amount and the freezer electrical power consumption amount multiplied by the primary energy conversion coefficient of electrical power, the value of the boiler gas consumption amount multiplied by the primary energy conversion coefficient of gas, and the value of the cogeneration fuel consumption amount multiplied by the primary energy conversion coefficient of biomass fuel, and is calculated by the following Equation (1).

[Equation 1]

$$E_c(d,t) = \alpha_e\big(e_d(d,t) + e_R(d,t)\big) + \alpha_g g_u(d,t) + \alpha_o o_u(d,t)$$

$$\cdots (1)$$

In the above, the values indicated by each of the parameters are as follows.

$e_d$ (d, t): Electrical power demand amount at time t on the d-th day from the start of the evaluation period (1-hour integrated value) (kWh)

$e_R$ (d, t): Freezer electrical power consumption amount at time t on the d-th day from the start of the evaluation period (1-hour integrated value) (kWh)

$o_u$ (d, t): Cogeneration fuel consumption amount at time t on the d-th day from the start of the evaluation period (1-hour integrated value) (kWh)

$g_u$ (d, t): Boiler gas consumption amount at time t on the d-th day from the start of the evaluation period (1-hour integrated value) (kWh)

$\alpha_e$: Primary energy conversion coefficient of electrical power [-]

$\alpha_g$: Primary energy conversion coefficient of gas [-]

$\alpha_o$: Primary energy conversion coefficient of biomass fuel [-]

The amount of primary energy production $E_g$ (d, t) at time t on the d-th day from the start of the evaluation period is the primary energy value converted from the sum of the amount of electrical power generation by a cogeneration system and the amount of electrical power generation by a solar power system, and is calculated by the following Equation (2).
[Equation 2]

$$E_g(d,t) = \alpha_e\big(e_{CGS}(d,t) + e_{PV}(d,t)\big)$$

$$\cdots (2)$$

In the above, the values indicated by each of the parameters are as follows.

$e_{CGS}$ (d, t): Amount of electrical power generation by a cogeneration system at time t on the d-th day from the start of the evaluation period (1-hour integrated value) (kWh)

$e_{PV}$ (d, t): Amount of electrical power generation by a solar power system at time t on the d-th day from the start of the evaluation period (1-hour integrated value) (kWh)

The integrated value $E_{ENT}$ (D, T) of the net amounts of primary energy consumption is calculated by the following Equation (3), based on the amount of primary energy consumption $E_c$ (d, t) indicated by Equation (1) and the amount of primary energy production $E_g$ (d, t) indicated by Equation (2).
[Equation 3]

$$E_{NET}(D,T) = \sum_{d=1}^{D}\sum_{t=0}^{T-1}\big(E_g(d,t) - E_c(d,t)\big)$$

$$\cdots (3)$$

The values indicated by the various parameters are as follows.

D: Number of days in the evaluation period
T: Number of data for each day in the evaluation period

In the present embodiment, the process data D1, the demand prediction data D7, and operation plan data D8 are, as an example, recorded in one-hour units. Therefore, because there are 24 data for the times in one day, T is 24. By Equation (1) to Equation (3), the calculator 153 calculates the integrated value of actual net amounts of primary energy consumption in the case of an actual value base and calculates the predicted value of integration of net amounts of primary energy consumption in the case of a predicted value base.

The description of the constitution of the energy management apparatus 1 will now be continued.

The ZEB possibility evaluator 154 performs processing to compare, to a prescribed threshold, the integrated value of actual net amounts of primary energy consumption or the predicted value of integration of net amounts of primary energy consumption indicated, respectively, by the primary energy actual data D6 and primary energy prediction data D9 stored in the computed result storage 134. Although as an example in this case, the prescribed threshold is made to zero for an evaluation is made of whether or not the building B (FIG. 1) can achieve being a ZEB, the prescribed threshold is not restricted to this.

Specifically, the ZEB possibility evaluator 154, for example, in the range over which the actual value is calculated, acquires the integrated value of actual net amounts of primary energy consumption indicated by the primary energy actual data D6 and the predicted value of integration of net amounts of primary energy consumption indicated by the primary energy prediction data D9.

The ZEB possibility evaluator 154 calculates the ratio of the integrated value of actual net amounts of primary energy consumption with respect to the predicted value of integration of net amounts of primary energy consumption corresponding to each date and time. By calculating the average value of the calculated ratio and multiplying the calculated average value by predicted value of integration of net amounts of primary energy consumption at each of the timings, the ZEB possibility evaluator 154 corrects the predicted value of integration of net amounts of primary energy consumption. The ZEB possibility evaluator 154 references the predicted integrated value for the 365th day from among the corrected predicted value of integration of net amounts of primary energy consumptions and determines whether or not the value is zero or negative. If the predicted integrated value corresponding to the 365th day is zero or negative, the ZEB possibility evaluator 154 makes an evaluation that it is possible to achieve being a ZEB. If the predicted integrated value corresponding to the 365th day is a positive value, the evaluation is that achieving being a ZEB is not possible.

The processing to correct the predicted integrated value performed by the ZEB possibility evaluator 154 is not restricting to being that described above. The ZEB possibility evaluator 154, for example , may correct the predicted integrated value corresponding to the 365th day regarding the integrated value of actual net amounts of primary energy consumption, based on the ratio corresponding to the most recent day of the ratio with respect to the predicted value of integration of net amounts of primary energy consumption. An evaluation of the possibility of the building B achieving being a ZEB may be made based on the predicted integrated value corresponding to the 365th day corrected in this manner.

If the predicted integrated value corresponding to the 365th day is zero or negative, the ZEB possibility evaluator 154 makes the evaluation that the building B can achieve being a ZEB. If the predicted integrated value corresponding to the 365th day is positive, the ZEB possibility evaluator 154 makes the evaluation that the building B cannot achieve being a ZEB. The ZEB possibility evaluator 154 stores the ZEB evaluation data D10, which indicates the result of evaluating whether or not the building B can achieve being a ZEB, into the calculation result storage 134. If the evaluation is that the building B cannot achieve being a ZEB, the ZEB possibility evaluator 154 outputs information to that effect to the performance evaluator 155.

Upon receiving a notification from the ZEB possibility evaluator 154 to the effect that the building B cannot achieve being a ZEB, the performance evaluator 155, based on the process data D1, the plant model data D4, the model parameter data D5, and the demand prediction data D7, makes an evaluation of whether or not the energy-supplying devices installed in the energy-supply plant P (FIG. 1) are exhibiting the expected performance. For example, if an offset exists between the value of the actual net amount of primary energy consumption and the predicted value of the net amount of primary energy consumption indicated, respectively by the primary energy actual data D6 and the primary energy prediction data D9, this enables the energy management apparatus 1 to identify the energy-supplying device that is the cause.

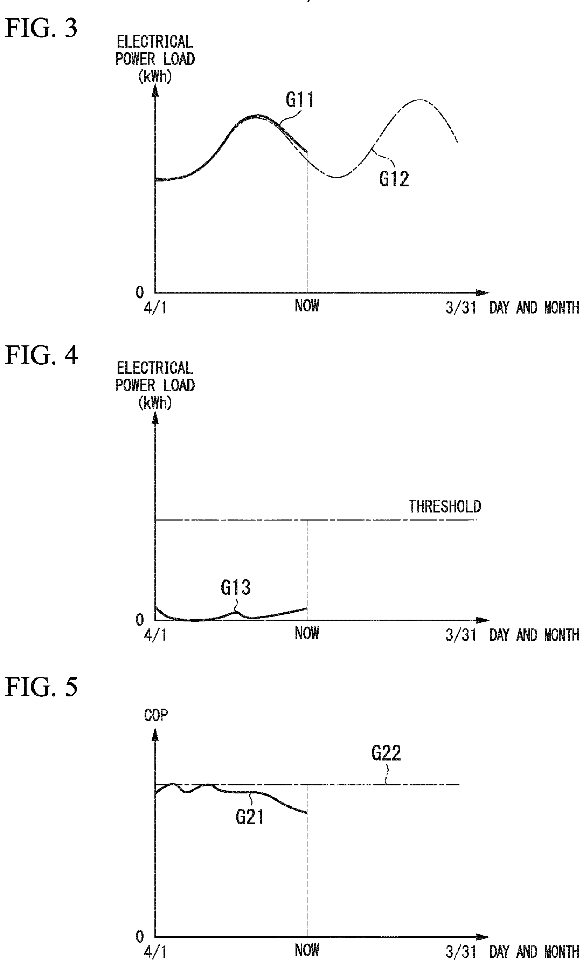

The processing by the performance evaluator 155 will now be described, with referencing being made to FIG. 3 to FIG. 5.

FIG. 3 and FIG. 4 show examples of the relationship between the predicted value and actual value of the electrical power load B1 calculated by the calculator 153.

In FIG. 3 and FIG. 4, the vertical axis represents electrical power load (kWh), and the horizontal axis represents the time (day and month). In FIG. 3, the curve G11 shows the time change of the actual value of the electrical power load B1 of the building B. In FIG. 3, the curve G12 shows the time change of the predicted value of the electrical power load B1 of the building B. In FIG. 4, the curve G13 shows the time change of the difference between the actual value and the predicted value of the electrical power load B1 of the building B. The curves G11 to G13 and the threshold and the like shown in FIG. 3 and FIG. 4, may be displayed, for example, by the terminal device 2 (FIG. 1).

The performance evaluator 155 compares the actual load values (for example, the curve G11 in FIG. 3) indicated by the process data D1 (electrical power load B1, heat load B2, and cold load B3) with the predicted load values (for example, the curve G12 in FIG. 3) indicated by the demand prediction data D7 (electrical power load B1, heat load B2, and cold load B3). If the result of the comparison is that the absolute value (for example, the curve G13 in FIG. 4) of the difference is larger than a pre-established threshold (for example FIG. 4), the performance evaluator 155 makes the evaluation that one or more of the energy-supplying device supplying energy to those loads is not exhibiting its expected performance. The performance evaluator 155 stores the performance evaluation data D11 indicating the results of the evaluation into the calculation result storage 134.

Before comparing the actual and predicted load values, the performance evaluator 155 may calculate the moving average of both actual value and the predicted value of the loads corresponding to each time, so as to smooth the actual and predicted values of the loads and then perform the comparison.

The performance evaluator 155 also makes a performance evaluation of each of the energy-supplying devices installed in the energy-supply plant P.

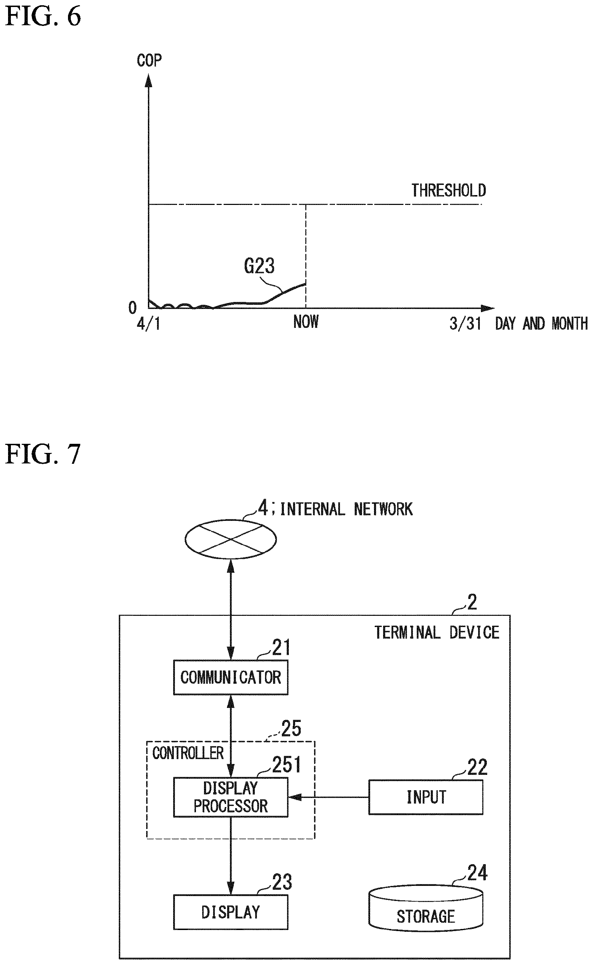

FIG. 5 and FIG. 6 show examples of the relationship between the predicted values and the actual values calculated by the calculator 153, regarding a performance evaluation index of an energy-supplying device.

In FIG. 5 and FIG. 6, the vertical axis indicates the COP, and the horizontal axis represents the time (day and month).

In FIG. 5, the curve G21 shows the time change of the actual value of the COP. In FIG. 5, the curve G22 shows the predicted value (designed value) of the COP. In FIG. 6, the curve G23 shows the difference between the actual and predicted COP values. The curves G21 to G23, the threshold and the like shown in FIG. 5 and FIG. 6 may be displayed, for example, by the terminal device 2 (FIG. 1).

Before comparing the actual and predicted COP values, the performance evaluator 155 may calculate the moving average of actual COP values corresponding each of the times, so as to smooth the actual values of the COP and then perform the comparison.

The performance evaluator 155, for example, calculates the performance evaluation index (the output energy conversion efficiency and energy generation efficiency with respect to the input energy, for example, the curve G21 in FIG. 5) from the actual values of input and output to and from each energy-supplying device indicated by the process data D1. The performance evaluator 155 acquires the performance evaluation index of each of the energy-supplying devices indicated by the model parameter data D5, and compares it with the performance evaluation index (for example the curve G22 in FIG. 5) calculated based on the process data D1. If the result of the comparison is that the absolute value of the difference (for example, the curve G23 in FIG. 6) is greater than a pre-established threshold, the performance evaluator 155 makes an evaluation that the expected performance is not being exhibited by the energy-supplying device. The performance evaluator 155 stores the performance evaluation data D11 indicating the evaluation result into the calculation result storage 134.

If the performance evaluator 155 makes the evaluation that an energy-supplying device is not exhibiting the expected performance, it updates information of the model parameter data D5, with the performance evaluation index calculated from the actual values of each of the energy-supplying device input and output indicated by the process data D1 (the output energy conversion efficiency with respect to the input energy and the energy generation efficiency) as the performance evaluation index of that energy-supplying device. The performance evaluator 155, for example, again outputs to the operation plan generator 152 a regeneration request for the operation plan data D8 based on the updated model parameter data D5, and also outputs to the calculator 153 a regeneration request for the primary energy prediction data D9 based on the operation plan data D8 regenerated by the operation plan generator 152.

Next, the constitution of the terminal device 2 will be described, with references being made to FIG. 7.

FIG. 7 is a block diagram showing the general constitution of the terminal device 2.

The terminal device 2 has a communicator 21, an input 22, a display 23, a storage 24, and a controller 25.

The communicator 21 has a communication interface and communicates with the energy management apparatus 1 (FIG. 1) via the internal network 4.

The input 22 has an input device such as a touch panel, a mouse, or a keyboard or the like and accepts operations from a user. Operations accepted by the input 22 are displayed, for example, on the display 23.

The display 23 has a display device such as a liquid crystal display or an organic EL (electroluminescence) display.

The storage 24 has, for example, a ROM, a ROM, or an EEPROM. The storage 24 may have an external storage device such as a HDD (hard-disk drive) or a flash memory. The storage 24 stores various programs for execution by a CPU (not shown) of the terminal device 2 and the results of processing executed by the CPU.

A part or all of the functions of the controller 25 are implemented, for example, by execution of a program stored in the storage 24 by a CPU of the terminal device 2.

The controller 25 has a display processor 251.

The display processor 251 displays various information on the display 23, based on operations accepted from the user by the input 22. For example, if the input 22 has accepted a request from the user to display the integrated value of actual net amounts of primary energy consumption of the building B (FIG. 1), the display processor 251 transmits to the energy management apparatus 1, via the communicator 21, a request to transmit the primary energy actual data D6. Upon acquiring the primary energy actual data D6 transmitted from the energy management apparatus 1 in response to the transmission request, the display processor 251 causes display on the display 23 of the integrated value of actual net amounts of primary energy consumption indicated by the acquired primary energy actual data D6.

For example, if the input 22 receives from the user a request to display the predicted value of integration of net amounts of primary energy consumption of the building B (FIG. 1), the display processor 251 transmits to the energy management apparatus 1, via the communicator 21, a request to transmit the primary energy prediction data D9. Upon acquiring the primary energy prediction data D9 transmitted from the energy management apparatus 1 in response to the transmission request, the display processor 251 causes display on the display 23 of the predicted value of integration of net amounts of primary energy consumption indicated by the acquired primary energy prediction data D9.

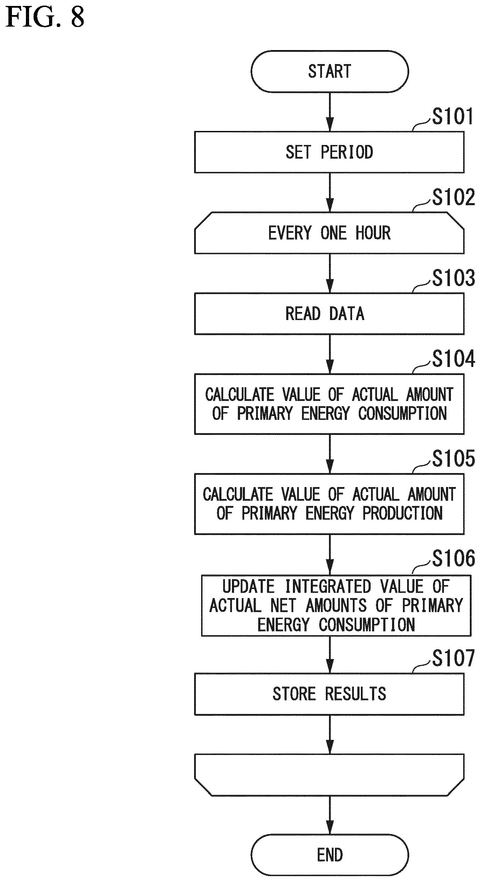

Next, the operation of the energy management apparatus 1 will be described, with references made to FIG. 8 to FIG. 13.

FIG. 8 is a flowchart showing the first example of the operation of the energy management apparatus 1 (FIG. 2).

In this case, the flow of processing to calculate the value of actual amount of the primary energy consumption, the value of actual amount of the primary energy production, and the integrated value of actual net amounts of primary energy consumption will be described.

(Step S101) First the input controller 144 (FIG. 2) stores the evaluation period data D3 accepted by the input 12 into the setting input storage 133, after which the controller of the energy management apparatus 1 proceeds to the processing of step S102.

(Step S102) Next, the calculator 153 (FIG. 2), during the evaluation period indicated by the evaluation period data D3 stored in the setting input data storage 133, executes the processing from step S103 to step S107, while advancing that time from the start of the evaluation period one hour at a time.

The controller of the energy management apparatus 1 repeats the processing of step S103 to step S107 until reaching the end of the evaluation period, after which the controller of the energy management apparatus 1 ends the processing shown in FIG. 8.

(Step S103) Next, the calculator 153 reads in from the process data storage 131 the process data D1 corresponding to the time within the evaluation period, and reads in from the setting input data storage 133 the plant model data D4 and the model parameter data D5, after which the controller of the energy management apparatus 1 proceeds to the processing of step S104.

(Step S104) Next, the calculator 153, based on Equation (1), calculates the value of an actual amount of primary energy consumption at that time, after which the controller of the energy management apparatus 1 proceeds to the processing of step S105.

(Step S105) Next, the calculator 153, based on Equation (2), calculates the value of an actual amount of primary energy production at that time, after which the controller of the energy management apparatus 1 proceeds to the processing of step S106.

(Step S106) Next, the calculator 153, based on Equation (3), calculates the value of an actual net amount of primary energy consumption at that time. The calculator 153 also updates the integrated value of actual net amounts of primary energy consumption by adding the calculated value of actual net amounts of primary energy consumption to the integrated value of actual net amounts of primary energy consumption up until that point, after which the controller of the energy management apparatus 1 proceeds to the processing of step S107.

(Step S107) Next, the calculator 153 stores into the calculation result storage 134 the primary energy actual data D6, which includes information of the value of actual amount of primary energy consumption, the value of actual amount of primary energy production for that date and time, and the integrated value of actual net amounts of primary energy consumption up until that date and time.

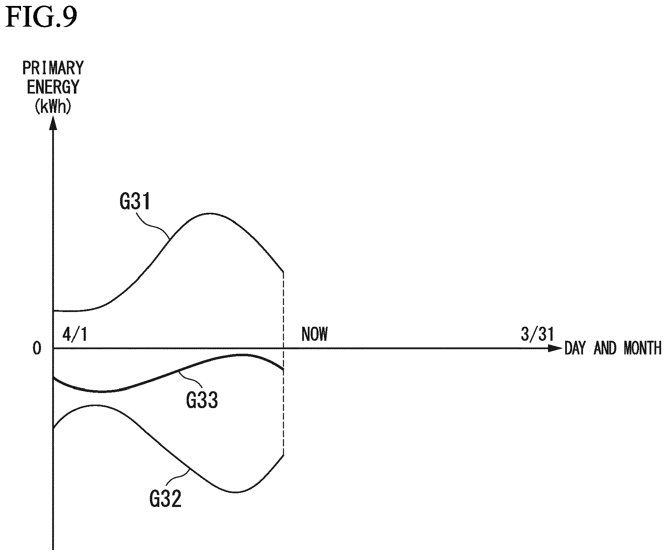

FIG. 9 shows an example of the relationship between the value of actual amount of primary energy consumption, the value of actual amount of primary energy production, and the integrated value of actual net amounts of primary energy consumption calculated by the energy management apparatus 1 (FIG. 2).

The values shown in FIG. 9 are calculated by the processing described using reference to FIG. 8. The curves G31 to G33 shown in FIG. 9 are displayed by the terminal device 2 (FIG. 7). In FIG. 9, the vertical axis represents the primary energy amount (kWh), and the horizontal axis indicates the time (day and month).

In the example shown in FIG. 9, the evaluation period is the one-year period from April 1 to March 31, and the horizontal axis time represents the period from April 1 to March 31. The curve G31 shows the change in the value of actual amounts of primary energy production over time. The curve G32 shows the change in the value of actual amount of primary energy consumption over time. The curve G33 shows the change in the integrated value of actual net amounts of negative primary energy consumption which represents the production of primary energy. In the example shown in FIG. 9, because "now" is within the evaluation period, the various values are calculated from April 1 only up until "now", and curves G31 to G33 show the time change of the actual value from April 1 until "now."

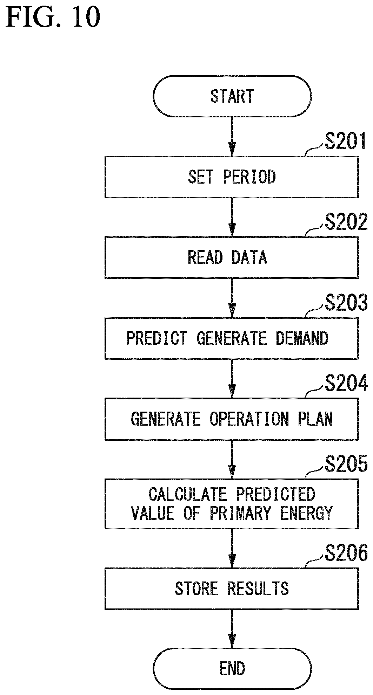

FIG. 10 is a flowchart showing the second example of the operation of the energy management apparatus 1 (FIG. 2).

In this case, the flow of processing to calculate the predicted value of the amounts of primary energy consumption,

the predicted value of the amounts of primary energy production, and the predicted value of integration of net amounts of primary energy consumption will be described.

(Step S201) First, the input controller 144 (FIG. 2) stores in the setting input data storage 133 the evaluation period data D3 accepted by the input 12, after which the controller of the energy management apparatus 1 proceeds to the processing of step S202.

(Step S202) Next, the demand predictor 151 (FIG. 2) reads in the process data D1 and the meteorological data D2 corresponding to the time of the evaluation period indicated by the evaluation period data D3 from the process data storage 131 and the meteorological data storage 132, respectively, after which the controller of the energy management apparatus 1 proceeds to the processing of step S203.

(Step S203) Next, the demand predictor 151, based on the read-in process data D1 and meteorological data D2, predicts the energy demand amount of the building B (FIG. 1) at each prescribed time in the evaluation period. The demand predictor 151 stores into the calculation result storage 134 the demand prediction data D7, which includes information indicating the results of predicting the energy demand amount, after which the controller of the energy management apparatus 1 proceeds to the processing of step S204.

(Step S204) Next, the operation plan generator 152 (FIG. 2), based on the plant model data D4 and the model parameter data D5 stored in the setting input data storage 133 and the demand prediction data D7 stored in the calculation result storage 134, generates an operation plan for each of the energy-supplying devices installed in the energy-supply plant P. The operation plan generator 152 stores the operation plan data D8 including information indicating the generated operation plan into the calculation result storage 134, after which the controller of the energy management apparatus 1 proceeds to the processing of step S205.

(Step S205) Next, the calculator 153 (FIG. 2), based on Equations (1) to (3), calculates the predicted value of the amount of primary energy consumption, the predicted value of the amount of primary energy production, and the predicted value of integration of net amounts of primary energy consumption at each time in the evaluation period, after which the controller of the energy management apparatus 1 proceeds to the processing of step S206.

(Step S206) Next, the calculator 153 stores into the calculation result storage 134 the primary energy actual data D6, which includes information indicating the predicted value of the amount of primary energy consumption, the predicted value of the amount of primary energy production, and the predicted value of integration of net amounts of primary energy consumption at each time in the evaluation period.

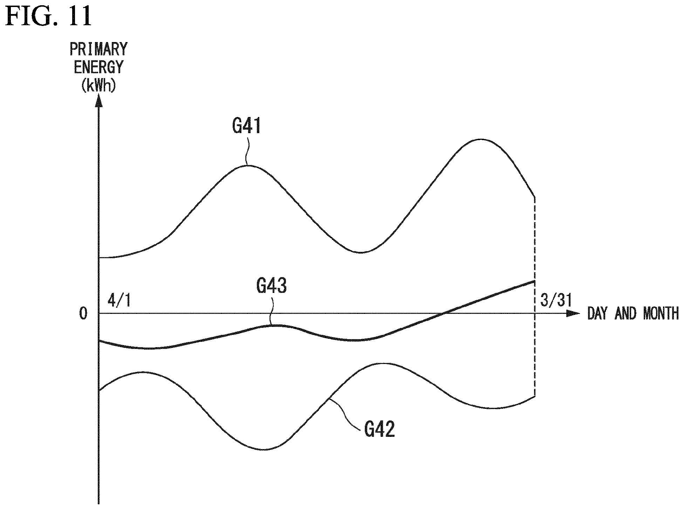

FIG. 11 shows one example of the relationship between the predicted value of the amount of primary energy consumption , the predicted value of the amount of primary energy production, and the predicted value of integration of net amounts of primary energy consumption calculated by the energy management apparatus 1 (FIG. 2).

Each of the values shown in FIG. 11 is calculated by processing that has been described with reference to FIG. 10. The curves G41 to G43 shown in FIG. 11 are, for example, displayed on the terminal device 2 (FIG. 7). In FIG. 11, the vertical axis represents the primary energy amount (kWh), and the horizontal axis represents the time (day and month). In the example shown in FIG. 11, the evaluation period is the one year from April 1 to March 31, the horizontal axis showing the period from April 1 to March 31. The curve G41 indicates the time change of the predicted value of the amount of primary energy production. The curve G42 shows the change in the amount of primary energy consumption over time. The curve G43 shows the change in the predicted value of integration of net amounts of negative primary energy consumption over time, wherein the negative primary energy consumption is the primary energy production.

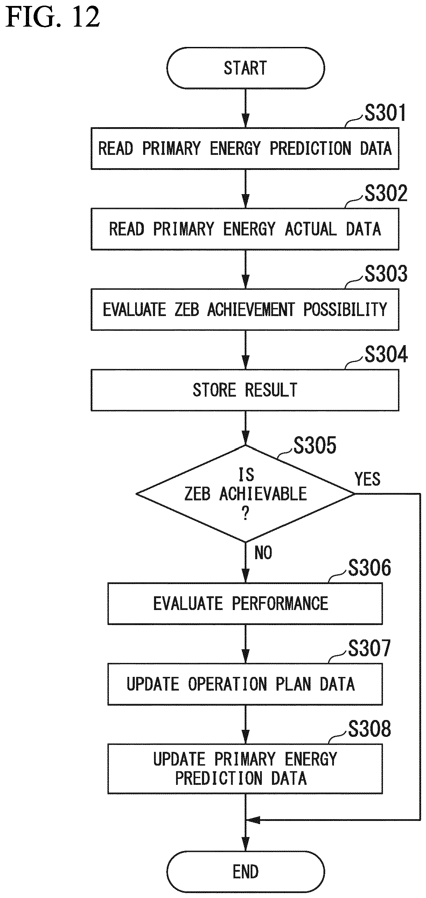

FIG. 12 is a flowchart showing the third example of the operation of the energy management apparatus 1 (FIG. 2).

In this case, the flow of processing to update the predicted values regarding the primary energy calculated by processing described with reference to FIG. 10 will be described.

(Step S301) First, the ZEB possibility evaluator 154 (FIG. 2) reads in the primary energy prediction data D9 from the calculation result storage 134, after which the controller of the energy management apparatus 1 proceeds to the processing of FIG. S302.

(Step S302) Next, the ZEB possibility evaluator 154 reads in the primary energy actual data D6 from the calculation result storage 134, after which the controller of the energy management apparatus 1 proceeds to the processing of step S303.

(Step S303) Next, the ZEB possibility evaluator 154 corrects the predicted value of integration of net amounts of primary energy consumption indicted by the primary energy prediction data D9, based on the integrated value of actual net amounts of primary energy consumption indicated by the primary energy actual data D6. Next, the ZEB possibility evaluator 154 evaluates whether or not the building B can achieve being a ZEB, based on the corrected predicted value of integration of net amounts of primary energy consumption, after which the controller of the energy management apparatus 1 proceeds to the processing of step S304.

(Step S304) Next, the ZEB possibility evaluator 154 generates the ZEB evaluation data D10, which includes information indicating the result of evaluating whether or not the building B can achieve being a ZEB. Next, the ZEB possibility evaluator 154 stores the generated ZEB evaluation data D10 into the calculation result storage 134, after which the controller of the energy management apparatus 1 proceeds to the processing of step S305.

(Step S305) Next, if the building B can achieve being a ZEB (YES), the controller of the energy management apparatus 1 ends the processing shown in FIG. 12. If the building B cannot achieve being a ZEB (NO), the controller of the energy management apparatus 1 proceeds to the processing of step S306.

(Step S306) Next, the performance evaluator 155 (FIG. 2) performs a performance evaluation of the energy-supplying devices installed in the energy-supply plant P (FIG. 1). Next, as a result of the performance evaluation, the performance evaluator 155, for energy-supplying devices evaluated as not exhibited the expected performance, by performance evaluation index calculated from the actual values of input and output with respect to that energy-supplying device indicated by the process data D1, updates the information of the performance evaluation index of that energy-supplying device in the model parameter data D5 stored in the setting input data storage 133. After that, the controller of the energy management apparatus 1 proceeds to the processing of step S307.

(Step S307) Next, the operation plan generator 152 (FIG. 2), based on the plant model data D4 and the model parameter data D5 and demand prediction data D7 updated at step S306, generates an operation plan for the energy-supplying devices installed in the energy-supply plant P. Next, the operation plan generator 152, by the information of the generated operation plan, updates the operation plan data D8 stored in the calculation result storage 134, after which the controller of the energy management apparatus 1 proceeds to the processing of step S308.

(Step S308) Next, the calculator 153 (FIG. 2), based on the plant model data D4, the model parameter data D5 and the demand prediction data D7 updated at step S306, and the operation plan data D8 updated at step S308, calculates the predicted value of the amount of primary energy consumption , the predicted value of the amount of primary energy production, and the predicted value of integration of net amounts of primary energy consumption for all energy-supplying devices installed in the energy-supply plant P. Next, the calculator 153 updates the primary energy prediction data D9 stored in the calculation result storage 134 by information of the various calculated predicted values, after which the controller of the energy management apparatus 1 ends the processing shown in this drawing.

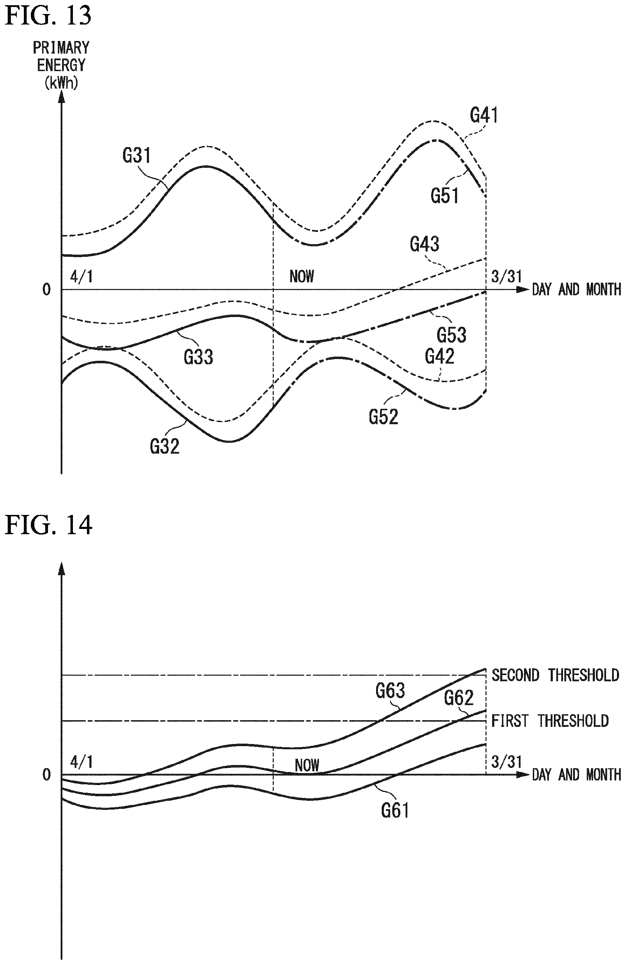

FIG. 13 shows one example of updating based on the actual value with respect to the predicted value of the amount of primary energy production, consumption amount predicted value, and net consumption amount predicted integrated value calculated by the energy management apparatus 1 (FIG. 1).

The various values shown in FIG. 13 are calculated by the processing described with reference to FIG. 8, FIG. 10 and FIG. 12. The curves G31 to G33, G41 to G43, and G51 to G53 shown in FIG. 13 are, for example, displayed by the terminal device 2 (FIG. 7). In FIG. 13, the vertical axis represents the primary energy amount (kWh), and the horizontal axis represents the time (day and month). In the example shown in FIG. 13, the evaluation period is the one year from April 1 to March 31, and the time of the horizontal axis shows the period from April 1 to March 31.

The curves G31 to G33, similar to FIG. 9, respectively show the change in actual amount of primary energy production over time, the change in actual amount of primary energy consumption over time, and the change in the integrated value of actual net amounts of negative primary energy consumption which is the primary energy production. The curves G41 to G43, similar to FIG. 11, respectively show the time change of the predicted value of the amount of primary energy production, the time change of the predicted value of the amount of primary energy consumption, and the time change in the predicted value of integration of net amounts of negative primary energy consumption which is the primary energy production. The curves G51 to G53, respectively show the predicted values indicated by the primary energy prediction data D9 updated by the processing at step S308. The curve G51 shows the time change of the predicted value of the amount of primary energy production after updating. The curve G52 shows the time change of the predicted value of the amount of primary energy consumption. The curve G53 shows the time change of the predicted value of integration of net amounts of negative primary energy consumption.

In the example shown in FIG. 13, the integrated value of the net amounts of negative primary energy consumption has an actual value lower than the predicted value, and there is a possibility that the building B will not achieve being a ZEB. One possible cause for this is that one or more of the energy-supplying devices installed in the energy-supply plant P (FIG. 1) is not exhibiting its expected performance. Given this, the energy management apparatus 1 compares the performance evaluation index set beforehand in the model parameter data D5 with the performance evaluation index calculated from the process data D1, and evaluates whether or not the energy-supplying devices are exhibiting their expected performance. If the evaluation is made that an energy-supplying device is not exhibiting its expected performance, the energy management apparatus 1, based on the performance evaluation index calculated from the process data D1, generates a new operation plan. This operation plan is generated based on a more accurate performance evaluation index. The calculator 153 then, based on the operation plan that was re-generated, calculates the predicted value of integration of net amounts of primary energy consumption. For example, this enables the energy management apparatus 1 to cause the building B to achieve being a ZEB more accurately.

FIG. 14 shows another example of the predicted value of integration of net amounts of primary energy consumption calculated by the energy management apparatus 1.

In FIG. 14, the vertical axis represents the primary energy (kWh), and the horizontal axis represents the time (day and month). In the example shown in FIG. 14, the evaluation period is the one year of March 31 to April 1, and the time of the horizontal axis represents the period from April 1 to March 31. The curves G61 to G63, the first threshold, and the second threshold shown in FIG. 14 are displayed, for example, by the terminal device 2 (FIG. 7). Each of the curves G61 to G63, respectively, show the time change of the predicted value of integration of net amounts of negative primary energy consumption, which is the primary energy production.

At the point in time when the one-year evaluation period of the building B ends, the curve G61 shows the time change of the predicted value of integration of net amounts of negative primary energy consumption on the operation plan generated under the constraining condition that the integrated value of net amounts of primary energy consumption be either zero or negative. At the point in time when the one-year evaluation period of the building B ends, the curve G62 shows the time change of the predicted value of integration of net amounts of negative primary energy consumption based on the operation plan generated under the constraining condition that integrated value of net amounts of primary energy consumption be no greater than the first threshold. At the point in time when the one-year evaluation period of the building B ends, the curve G63 shows the time change of the predicted value of integration of net amounts of negative primary energy consumption based on the operation plan generated under the constraining condition that integrated value of net amounts of primary energy consumption be no greater than the second threshold.

In this manner, the energy management apparatus 1 may generate an operation plan regarding the building B so that, for example, the integrated value of net amounts of primary energy consumption is less than a prescribed threshold that is other than zero. This enables the energy management apparatus 1 to make the integrated value of net amounts of primary energy consumption regarding the building B smaller or larger at the end of the evaluation period. For example, even if the condition for granting an award of a subsidy is the net amount of primary energy consumption being at least a prescribed amount, the energy management apparatus 1 can generate an operation plan and control the energy-supplying devices installed in the energy-supply plant P, so as to achieve that condition. The terminal device 2 can display in easy-to-understand form whether or not the condition can be achieved.

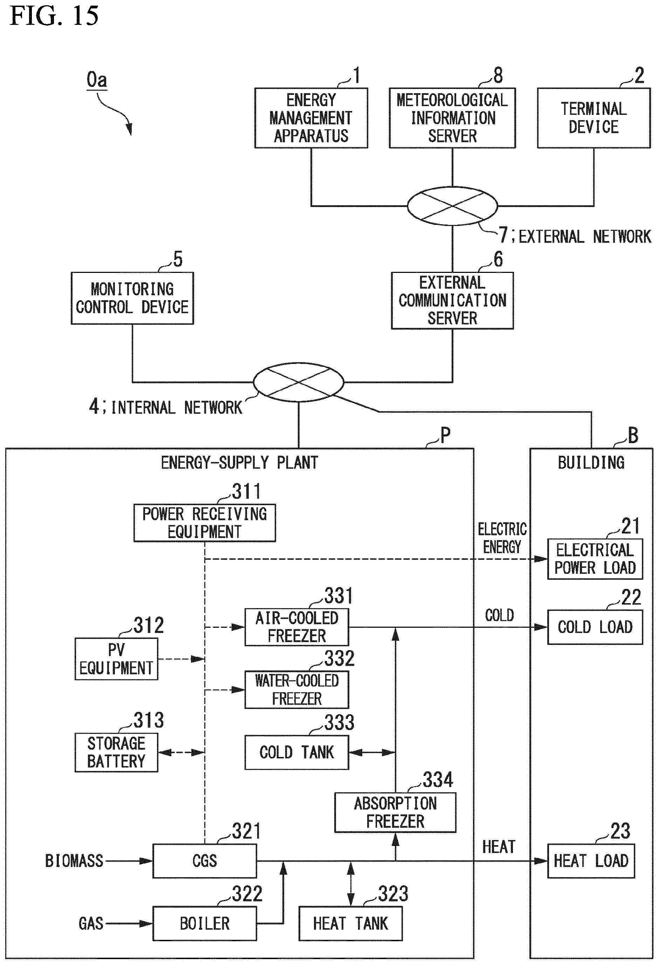

Next the operation of the energy management apparatus 1 will be described, with references made to FIG. 15.

An energy management system 0a according to a variation example has, similar to the energy management system 0, an energy management apparatus 1, a terminal device 2, a plurality of energy-supplying devices, a monitoring control device 5, and an external communication server 6. In the energy management system 0a, however, the form of connection of the various devices differs from that of the energy management system 0. Specifically, whereas in the energy management system 0 the energy management apparatus 1 and the terminal device 2 are connected to the internal network 4, in the energy management system 0a, the energy management apparatus 1 and the terminal device 2 are connected to an external network 7. In the energy management system 0a, the energy management apparatus 1 receives various data from the monitoring control device 5, via the external communication server 6, and executes the various above-described processing.

In this manner, either one or both of the energy management apparatus 1 and the terminal device 2 may be connected to the external network 7, and the energy management system 0a provide a so-called cloud service to a user.

In the above-described embodiment, the constitutions of the various devices may be provided separately in different apparatuses. For example, the demand predictor 151, the operation plan generator 152, the calculator 153, the ZEB possibility evaluator 154, and the performance evaluator 155 of the energy management apparatus 1 may each be provided in a separate apparatuses. The process data storage 131, the meteorological data storage 132, the setting input data storage 133, and the calculation result storage 134 may each be provided in a separate apparatus. If these constituent elements are provided in different apparatuses, the functions of the above-described energy management apparatus 1 may be implemented by passing the information input to and output from the various constituent elements by communication between the apparatuses. In the above-described embodiment, the functions of a plurality of apparatuses of the energy management system 0 may be implemented by a single apparatus. For example, the display 23 and the display processor 251 of the terminal device 2 may be provided in the energy management apparatus 1. The energy management apparatus 1, for example, may display arbitrary information, based on various data stored in the calculation result storage 134.

In the above-described embodiment, the format of the display by the display 23 of the terminal device 2 is not restricted to that described above. For example, the terminal device 2 may display as, for example, a table, information of the various curves shown in FIG. 3 to FIG. 6, FIG. 9, FIG. 11, FIG. 13, and FIG. 14. For example, the terminal device 2 may display various arbitrary curves as described above in overlapped fashion.

In the above-described embodiment, the information displayed by the display 23 of the terminal device 2 is not restricted to that described above. For example, the terminal device 2 may display the various above-described thresholds. Also, for example, the terminal device 2 may display arbitrary information included in arbitrary data from among the process data D1 stored in the energy management apparatus 1, the meteorological data D2 stored in the meteorological data storage 132, the evaluation period data D3, plant model data D4, and model parameter data D5 stored in the setting input data storage 133, and the primary energy actual data D6, the demand prediction data D7, the operation plan data D8, the primary energy prediction data D9, ZEB evaluation data D10, and the performance evaluation data D11 stored in the calculation result storage 134. For example, the terminal device 2 may acquire the ZEB evaluation data D10 from the energy management apparatus 1 and display the evaluation result of whether or not the building B can achieve being a ZEB by a character string. Also, for example, the terminal device 2 may acquire the performance evaluation data D11 and indicate this by a display of energy-supplying devices that are evaluated as not exhibiting the expected performance.

According to at least one of the embodiments described above, by having a calculator that calculates the actual value and the prediction value for integration of net amounts of primary energy consumption in a prescribed period, an easy-to-understand presentation can be made of the integrated value of the net amounts of primary energy consumption.

A part or all of the energy management apparatus 1 (FIG. 2) and the terminal device 2 (FIG. 7) in the above-described embodiments, for example, the controller of the energy management apparatus 1 and the controller 25 of the terminal device 2 (FIG. 7), may be implemented by a computer. In that case, the functions may be implemented by a program for implementing these functions being recorded in a computer-readable recording medium and by a computer system being made to read in and execute the program stored in the recording medium. In this case "computer system" is a computer system built into either the energy management apparatus 1 or the terminal device 2, and includes an operating system (OS) and hardware such as peripheral devices.

The term "computer-readable recording medium" refers to a removable medium such as a flexible disk, a magneto-optical disk, a ROM, or a CR-ROM, or to a storage device such as a hard-disk building into a computer system. Additionally, the term "computer-readable recording medium" may include one that holds a program for a short period of time dynamically, such as the case of a communication line that transmits a program via a communication circuit such as a network of the Internet or a telephone line, in which case one that holds a program for a certain time such as in a volatile memory within a computer serving as a server or client may be included. The above-noted program may be one for implementing a part of the above-described functions, and the above-described functions may be implemented in combination with a program already recorded in the computer system.

A part or all of the energy management apparatus 1 and the terminal device 2 in the above-described embodiments may be implemented as an integrated circuit such as an LSI (large-scale integration) device. The functions of the energy management apparatus 1 and the terminal device 2 may implemented as separate processor or a part or all thereof may be integrated into a processor. The method of integrating the circuit is not restricted to LSI, and it may be implemented by a dedicated circuit or a general-purpose processor. Also, in the event of the appearance of art for integrating circuits that replaces LSI by advanced semiconductor techniques, an integrated circuit using that art may be used.

While certain embodiments of the present inventions have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

**Claims**

1. An information processing apparatus comprising:

   a calculator that acquires an amount of primary energy consumption at timings in a period of time and an amount of primary energy production at timings in the period of time, the amount of primary energy consumptions having been consumed and/or being estimated to be consumed by a plurality of energy-supplying apparatuses configured to supply energy to a load, the amount of primary energy productions having been produced and/or being estimated to be produced by the plurality of energy-supplying apparatuses,
   the calculator that calculates a net amount of primary energy consumption at the timings in the period of time, based on the acquired amount of primary energy consumption and the amount of primary energy production, and
   the calculator that calculates an integrated value of the net amounts of primary energy consumption over the period of time, based on the net amounts of primary energy consumption calculated at the timings in the period of time.

2. The information processing apparatus according to claim 1, further comprising:

   a primary energy evaluator that makes an evaluation of whether or not the integrated value of net amounts of primary energy consumption calculated by the calculator is at least a threshold.

3. The information processing apparatus according to claim 2,
   wherein the calculator calculates a predicted value and an actual value regarding the integrated value of the net amounts of primary energy consumption over the period of time, and
the primary energy evaluator corrects the predicted value of integration of net amounts of primary energy consumption calculated by the calculator, based on the integrated value of the actual net amounts of primary energy consumption calculated by the calculator, and
the primary energy evaluator makes an evaluation of whether or not the corrected integrated value of the net amounts of primary energy consumption is at least the threshold.

4. The information processing apparatus according to claim 1 further comprising:

a process data acquisitor that acquires process data indicating an operating condition of a first energy-supplying device of the plurality of energy-supplying devices; and
a performance evaluator that makes an evaluation of whether or not the first energy-supplying device has exhibited an expected performance, based on the process data acquired by the process data acquisitor.

5. The information processing apparatus according to claim 4,
wherein the performance evaluator calculates an energy conversion efficiency or an energy generation efficiency of the first energy-supplying device, based on the process data acquired by the process data acquisitor, and
the information processing apparatus comprises an operation plan generator that generates the operation plan of the first energy-supplying device, based on the energy conversion efficiency or the energy generation efficiency of the first energy-supplying device calculated by the performance evaluator.

6. An information processing method comprising:

acquiring an amount of primary energy consumption at timings in a period of time and an amount of primary energy production at timings in the period of time, the amount of primary energy consumptions having been consumed and/or being estimated to be consumed by a plurality of energy-supplying apparatuses configured to supply energy to a load, the amount of primary energy productions having been produced and/or being estimated to be produced by the plurality of energy-supplying apparatuses;
calculating a net amount of primary energy consumption at the timings in the period of time, based on the acquired amount of primary energy consumption and the amount of primary energy production; and
calculating an integrated value of the net amounts of primary energy consumption over the period of time, based on the net amounts of primary energy consumption calculated at the timings in the period of time.

7. A storage medium that stores a program, when executed, to cause a computer of an information processing apparatus to perform:

acquiring an amount of primary energy consumption at timings in a period of time and an amount of primary energy production at timings in the period of time, the amount of primary energy consumptions having been consumed and/or being estimated to be consumed by a plurality of energy-supplying apparatuses configured to supply energy to a load, the amount of primary energy productions having been produced and/or being estimated to be produced by the plurality of energy-supplying apparatuses;
calculating a net amount of primary energy consumption at the timings in the period of time, based on the acquired amount of primary energy consumption and the amount of primary energy production; and
calculating an integrated value of the net amounts of primary energy consumption over the period of time, based on the net amounts of primary energy consumption calculated at the timings in the period of time.

# FIG. 1

0

8
METEOROLOGICAL
INFORMATION
SERVER

7; EXTERNAL NETWORK

5
MONITORING
CONTROL
DEVICE

1
ENERGY
MANAGEMENT
APPARATUS

6
EXTERNAL
COMMUNICATION
SERVER

4; INTERNAL NETWORK

P
ENERGY-SUPPLY PLANT

311
POWER RECEIVING
EQUIPMENT

ELECTRIC
ENERGY

B
BUILDING

B1
ELECTRICAL
POWER LOAD

331
AIR-COOLED
FREEZER

COLD

B3
COLD LOAD

312
PV
EQUIPMENT

332
WATER-COOLED
FREEZER

313
STORAGE
BATTERY

333
COLD TANK

334
ABSORPTION
FREEZER

321
BIOMASS → CGS

HEAT

B2
HEAT LOAD

322
GAS → BOILER

323
HEAT TANK

2
TERMINAL
DEVICE

# FIG. 2

ENERGY MANAGEMENT APPARATUS — 1

4 ; INTERNAL NETWORK

COMMUNICATOR — 11

INPUT — 12

DATA TRANSMITTER — 143

PROCESS DATA ACQUISITOR — 141

METEOROLOGICAL DATA ACQUISITOR — 142

INPUT CONTROLLER — 144

PROCESS DATA STORAGE — 131
- PROCESS DATA ~ D1

METEOROLOGICAL DATA STORAGE — 132
- METEOROLOGICAL DATA ~ D2

SETTING INPUT DATA STORAGE — 133
- EVALUATION PERIOD DATA ~ D3
- PLANT MODEL DATA ~ D4
- MODEL PARAMETER DATA ~ D5

CALCULATION RESULT STORAGE — 134
- PRIMARY ENERGY ACTUAL DATA ~ D6
- DEMAND PREDICTION DATA ~ D7
- OPERATION PLAN DATA ~ D8
- PRIMARY ENERGY PREDICTION DATA ~ D9
- ZEB EVALUATION DATA ~ D10
- PERFORMANCE EVALUATION DATA ~ D11

PROCESSOR — 15
- DEMAND PREDICTOR — 151
- OPERATION PLAN GENERATOR — 152
- ZEB POSSIBILITY EVALUATOR (PRIMARY ENERGY EVALUATOR) — 154
- CALCULATOR — 153
- PERFORMANCE EVALUATOR — 155

EP 3 168 948 A1

FIG. 3

ELECTRICAL
POWER LOAD
(kWh)

G11

G12

0
4/1                    NOW                    3/31   DAY AND MONTH

FIG. 4

ELECTRICAL
POWER LOAD
(kWh)

THRESHOLD

G13

0
4/1                    NOW                    3/31   DAY AND MONTH

FIG. 5

COP

G22

G21

0
4/1                    NOW                    3/31   DAY AND MONTH

FIG. 6

FIG. 7

FIG. 8

```
                    ┌─────────────────┐
                    │      START      │
                    └─────────────────┘
                             │
                             ▼            ╭S101
                    ┌─────────────────┐
                    │   SET PERIOD    │
                    └─────────────────┘
                             │
                             ▼            ╭S102
                  ⟨  EVERY ONE HOUR  ⟩
                             │
                             ▼            ╭S103
                    ┌─────────────────┐
                    │    READ DATA    │
                    └─────────────────┘
                             │
                             ▼            ╭S104
          ┌────────────────────────────────────┐
          │ CALCULATE VALUE OF ACTUAL AMOUNT    │
          │ OF PRIMARY ENERGY CONSUMPTION       │
          └────────────────────────────────────┘
                             │
                             ▼            ╭S105
          ┌────────────────────────────────────┐
          │ CALCULATE VALUE OF ACTUAL AMOUNT    │
          │ OF PRIMARY ENERGY PRODUCTION        │
          └────────────────────────────────────┘
                             │
                             ▼            ╭S106
          ┌────────────────────────────────────┐
          │ UPDATE INTEGRATED VALUE OF          │
          │ ACTUAL NET AMOUNTS OF PRIMARY       │
          │ ENERGY CONSUMPTION                  │
          └────────────────────────────────────┘
                             │
                             ▼            ╭S107
          ┌────────────────────────────────────┐
          │         STORE RESULTS              │
          └────────────────────────────────────┘
                             │
                             ▼
                  ⟨                  ⟩
                             │
                             ▼
                    ┌─────────────────┐
                    │       END       │
                    └─────────────────┘
```

FIG.9

FIG. 10

```
        ┌─────────────┐
        │    START    │
        └─────────────┘
               │
               ▼           ╭S201
        ┌─────────────────┐
        │   SET PERIOD    │
        └─────────────────┘
               │
               ▼           ╭S202
        ┌─────────────────┐
        │    READ DATA    │
        └─────────────────┘
               │
               ▼           ╭S203
        ┌──────────────────────┐
        │ PREDICT GENERATE DEMAND │
        └──────────────────────┘
               │
               ▼           ╭S204
        ┌──────────────────────┐
        │ GENERATE OPERATION PLAN │
        └──────────────────────┘
               │
               ▼           ╭S205
        ┌──────────────────────┐
        │  CALCULATE PREDICTED   │
        │ VALUE OF PRIMARY ENERGY │
        └──────────────────────┘
               │
               ▼           ╭S206
        ┌─────────────────┐
        │  STORE RESULTS  │
        └─────────────────┘
               │
               ▼
        ┌─────────────┐
        │     END     │
        └─────────────┘
```

FIG. 11

# FIG. 12

START

↓ S301

READ PRIMARY ENERGY PREDICTION DATA

↓ S302

READ PRIMARY ENERGY ACTUAL DATA

↓ S303

EVALUATE ZEB ACHIEVEMENT POSSIBILITY

↓ S304

STORE RESULT

↓ S305

IS ZEB ACHIEVABLE ? — YES →

↓ NO

↓ S306

EVALUATE PERFORMANCE

↓ S307

UPDATE OPERATION PLAN DATA

↓ S308

UPDATE PRIMARY ENERGY PREDICTION DATA

↓

END

EP 3 168 948 A1

FIG. 13

FIG. 14

27

FIG. 15

0a

| ENERGY MANAGEMENT APPARATUS | 1 | METEOROLOGICAL INFORMATION SERVER | 8 | TERMINAL DEVICE | 2 |

7; EXTERNAL NETWORK

| MONITORING CONTROL DEVICE | 5 |

| EXTERNAL COMMUNICATION SERVER | 6 |

4; INTERNAL NETWORK

ENERGY-SUPPLY PLANT   P

BUILDING   B

| POWER RECEIVING EQUIPMENT | 311 |

ELECTRIC ENERGY

| ELECTRICAL POWER LOAD | 21 |

| PV EQUIPMENT | 312 |

| AIR-COOLED FREEZER | 331 |

COLD

| COLD LOAD | 22 |

| WATER-COOLED FREEZER | 332 |

| STORAGE BATTERY | 313 |

| COLD TANK | 333 |

| ABSORPTION FREEZER | 334 |

BIOMASS → | CGS | 321 |

GAS → | BOILER | 322 |

| HEAT TANK | 323 |

HEAT

| HEAT LOAD | 23 |

## INTERNATIONAL SEARCH REPORT

| International application No. |
|---|
| PCT/JP2015/069282 |

| A. CLASSIFICATION OF SUBJECT MATTER |
|---|
| *H02J3/00*(2006.01)i, *G06Q50/06*(2012.01)i |

According to International Patent Classification (IPC) or to both national classification and IPC

| B. FIELDS SEARCHED |
|---|

Minimum documentation searched (classification system followed by classification symbols)
H02J3/00, G06Q50/06

Documentation searched other than minimum documentation to the extent that such documents are included in the fields searched
| Jitsuyo Shinan Koho | 1922–1996 | Jitsuyo Shinan Toroku Koho | 1996–2015 |
| Kokai Jitsuyo Shinan Koho | 1971–2015 | Toroku Jitsuyo Shinan Koho | 1994–2015 |

Electronic data base consulted during the international search (name of data base and, where practicable, search terms used)

| C. DOCUMENTS CONSIDERED TO BE RELEVANT |
|---|

| Category* | Citation of document, with indication, where appropriate, of the relevant passages | Relevant to claim No. |
|---|---|---|
| Y | JP 2011-180807 A (Sekisui Chemical Co., Ltd.), 15 September 2011 (15.09.2011), paragraphs [0030] to [0055], [0098] to [0153]; fig. 2 to 6 (Family: none) | 1-7 |
| Y | JP 2007-336656 A (Toyota Motor Corp.), 27 December 2007 (27.12.2007), paragraphs [0001], [0040] to [0080]; fig. 3 to 11 (Family: none) | 1-7 |

| ☒ Further documents are listed in the continuation of Box C. | ☐ See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 16 September 2015 (16.09.15) | 06 October 2015 (06.10.15) |

| Name and mailing address of the ISA/ | Authorized officer |
|---|---|
| Japan Patent Office 3-4-3,Kasumigaseki,Chiyoda-ku, Tokyo 100-8915,Japan | |
| | Telephone No. |

Form PCT/ISA/210 (second sheet) (July 2009)

**INTERNATIONAL SEARCH REPORT**

| International application No. |
|---|
| PCT/JP2015/069282 |

C (Continuation).   DOCUMENTS CONSIDERED TO BE RELEVANT

| Category* | Citation of document, with indication, where appropriate, of the relevant passages | Relevant to claim No. |
|---|---|---|
| Y | JP 2014-50275 A  (Toshiba Corp.),<br>17 March 2014 (17.03.2014),<br>paragraphs [0001] to [0008], [0010] to [0075];<br>fig. 1 to 8<br>& US 2014/0142774 A1    & WO 2014/034391 A1<br>& EP 2894747 A | 1-7 |
| Y<br>A | JP 2007-207488 A  (Nissan Motor Co., Ltd.),<br>16 August 2007 (16.08.2007),<br>paragraphs [0010] to [0012], [0021] to [0078];<br>fig. 2 to 22<br>& US 2009/0011301 A1    & WO 2007/088449 A1<br>& EP 1984971 A1          & CA 2640633 A1 | 3-5<br>1,2,6,7 |

Form PCT/ISA/210 (continuation of second sheet) (July 2009)

**EP 3 168 948 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2012103811 A